# EUROPEAN PATENT APPLICATION

(11) **EP 2 251 718 A1**
(43) Date of publication of application: **17.11.2010**
(21) Application number: 10162292.6
(22) Date of filing: 07.05.2010
(51) Int. Cl.: G02B 5/18, G02B 5/20, H01L 27/146

(54) **Metal optical filter capable of photo lithography process and image sensor including the same**

(30) Priority: 11.05.2009 KR 20090040546
(71) Applicant: SiliconFile Technologies Inc., Seoul (KR)
(72) Inventor: Lee, Byoung Su, Jeollanam-do (KR); Kim, Shin, Seoul (KR); Lee, Sang Shin, Seoul (KR); Yoon, Yeo Taek, Seoul (KR)
(74) Representative: Neobard, William John

(57) **Abstract**

Disclosed is a metal optical filter capable of a photo-lithography process and an image sensor including the same, and more particularly, a metal optical filter capable of a photo-lithography process, which can quite freely adjust the transmission band and transmittance thereof, even with a small number of metal layers, and simultaneously, can be actually applied in a CMOS process because it is possible to achieve nanoscale patterning by the photo-lithography process, and an image sensor including the metal optical filter. The metal optical filter capable of a photo-lithography process includes a plurality of metal rods arranged in parallel with each other at an equal nanoscale interval; and an insulation material formed between the plurality of metal rods and on upper and lower surfaces of the plurality of metal rods, wherein the metal rod is formed to comprise an upper Ti layer, an Al layer, and a lower TiN layer.

## Description

The present invention relates to a metal optical filter capable of a photo-lithography process and an image sensor including the same. Embodiments relate to a metal optical filter capable of a photo-lithography process, which can quite freely adjust the transmission band and transmittance thereof, even with a small number of metal layers, and simultaneously, can be actually applied in a CMOS process because it is possible to achieve nanoscale patterning by the photo-lithography process, and an image sensor including the metal optical filter.

Generally, an optical filter is fabricated in such a manner as to stack two or more dielectric materials having different refractive indices. Specifically, an optical filter is obtained generally in such a manner that two or more materials having different refractive indices are stacked in several tens of layers having various thicknesses on a glass substrate. The optical filter fabricated in such a manner can have a desired band characteristic and transmittance. However, such an optical fiber is fabricated using materials incompatible with a CMOS process, and has a difficulty in applying to a CMOS process for mass production because the optical fiber requires a process of stacking several tens of layers.

In order to replace such an optical fiber, many studies have been conducted on technology about optical filters implemented by a small number of layers. A representative technology is a scheme using a Fabry-Perot resonator, which is to control a transmission band, for example, by inserting layers with different thicknesses between SiO2/TiO2 layers in a specific period. The technology using the Fabry-Perot resonator has an advantage in that the process can be accomplished with a small number of layers, while having disadvantages in that a peculiar process such as Ti02 is required and it is difficult to form a pattern. That is, the scheme has difficulty in implementing a selective transmission characteristic that allows first and second regions to have first and second transmission bands, respectively, on a semiconductor substrate.

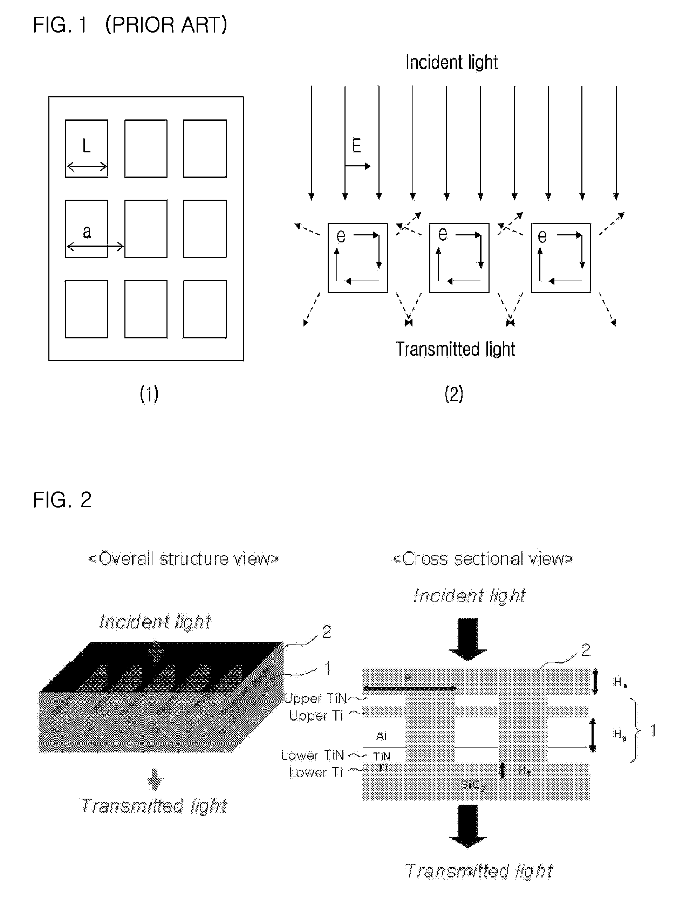

In order to solve such disadvantages, the metal nano-pattern filter technology to form a pattern (i.e. nano-pattern) of a nano unit on a metal layer has been proposed. The technology is to form a pattern of nano size (approximately 40 nm) on a metal thin film (mainly, an Ag thin film), and uses the characteristics of the surface plasmon resonance (see FIG. 1), that represents the transmission characteristic of light by allowing electrons excited by an electric field of irradiated light to move along a limited metal surface and to radiate light.

When light is incident to a metal thin film, electrons within the metal vibrate while moving along an electric field perpendicular to the incident direction of light (surface plasmon). The incident light is attenuated by electrons which have moved as described above, so that the incident light cannot be transmitted over a predetermined penetration depth Lp. That is to say, light decreases in the form of an exponential function of a penetration depth Lp within the metal. Therefore, visible light cannot be transmitted through a metal thin film having a thickness of approximately 100 nm or more.

However, research has been conducted on transmission characteristics when a metal thin film has a nanoscale pattern less than the wavelength of incident light, which is regarded as an important subject in Bio Photonics, Optics, etc., and it has been known that, when a metal thin film with a thickness of several hundred nanometer has a pattern less than the wavelength of light, the light is abnormally transmitted.

That is to say, a metal thin film with a nanoscale pattern can take charge of an optical filter. Such a structure has an advantage in that it is possible to control only light in a determined band to be transmitted or absorbed by adjusting the size of a nano-pattern of metal or the like.

FIG. 1 is a view illustrating a band-pass filter which has a nano-pattern formed on a metal layer.

In this case, the thickness of the metal layer is determined depending on the bandwidth of a wavelength of light to be transmitted, and it is preferred that the metal layer has a thickness of approximately 100 to 5000 nm. In addition, it is advantageous that the thickness of the metal layer is thin when the bandwidth of a wavelength of light to be transmitted is wide, and that the thickness of the metal layer is thick when the bandwidth is narrow.

It is preferred that the metal layer is made of transition metal, such as Al, Ag, Au, Pt, Cu, etc., having a high conductivity. The distance "a" between periodic patterns of a metal layer is determined depending on the wavelength of light to be transmitted, and must be less than the wavelength of the light to be transmitted. Also, since the length L of an open interval determines a transmittance, it is preferred that the pattern is formed as large as possible.

For example, when the width of a metal wiring is limited to 90 nm, the length L of the open interval may be determined by "L=a-50 [nm]."

The principle that light transmits a metal layer with a nano-pattern will now be described with reference to FIG. 1.

When light is incident to a metal layer with a nano-pattern, electrons "e" moves by an electric field formed by the incident light, and the moving electrons travel along the shape of the metal. Therefore, strong radiation is caused at the edges of the metal, so that transmitted light is generated by strong resonance when the nano-pattern of the metal is matched with the incident light. Accordingly, when electrons within a metal layer move in a sharply bent form, much light is transmitted.

The central wavelength λ*_{c}* of light transmitting the metal layer may be approximately determined by the following equation.

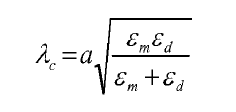

Here, ε*ₘ* represents a real number permittivity of a metal, and ε*_{d}* represents a real number permittivity of a medium. Such a filter using a metal layer has an advantage in that it is possible to form a filter having a desired wavelength and bandwidth by changing the structure of the metal layer.

This technology has an advantage in that it is possible to obtain a desired band and transmittance by adjusting the thickness of a metal and the periodic characteristic of a metal lattice, while having disadvantages in that Ag incapable of applying to a CMOS process is used, and that it is difficult to apply the filter to a photo-lithography process because metal having a high reflectivity is used. That is to say, when photoresist is applied to the surface of a metal and then exposure is performed using a photo mask, light of an adjacent exposure area is reflected to the surface of the metal, so that photoresist of an area which must not be exposed is exposed, thereby making it impossible to form a pattern. Therefore, generally, such a metal optical filter is fabricated using e-beam lithography or a nano-imprint scheme, which does not use a photo-lithography process. However, the nano-imprint scheme is still in the research stage until now, and the e-beam lithography process costs a great deal, so that it is difficult to apply the e-beam lithography process for mass production.

Accordingly, the present invention has been made in an effort to solve the problems occurring in the related art, and an object of embodiments is to provide a metal optical filter which can be actually applied to a photo-lithography process and CMOS process by using Al, TiN, and Ti used in a CMOS process and forming a TiN layer as the uppermost layer, so as to solve the problem of the conventional metal nano-pattern filter technology, and an image sensor including the metal optical filter.

In one aspect, there is provided a metal optical filter capable of a photo-lithography process, the metal optical filter comprising: a plurality of metal rods arranged in parallel with each other at an equal nanoscale interval; and an insulation material formed between the plurality of metal rods and on upper and lower surfaces of the plurality of metal rods, wherein the metal rod is formed to comprise an upper Ti layer, an Al layer, and a lower TiN layer.

In another aspect, there is provided a metal optical filter capable of a photo-lithography process, the metal optical filter comprising: a lower TiN layer; an Al layer formed on an upper surface of the lower TiN layer; and an upper TiN layer formed on an upper surface of the Al layer, wherein a plurality of nanoscale apertures are patterned on the upper TiN layer, the Al layer, and the lower TiN layer.

In still another aspect, there is provided an image sensor comprising a metal optical filter capable of a photo-lithography process, the image sensor comprising: a substrate having a photodiode region which detects light, a vertical charge transfer region which is a charge transfer path where electric charges generated by an photoelectric effect in the photodiode region are collected, and an isolation layer; a gate insulation film formed on the substrate; a gate electrode formed on the gate insulation film; an interlayer insulation film formed on the substrate having the gate electrode; and at least one metal layer formed with an insulation film interposed therebetween to provide a circuit wiring within the interlayer insulation film, wherein the at least one metal layer corresponds to a metal optical filter in which a plurality of nanoscale apertures are patterned on the upper TiN layer/the Al layer/the lower TiN layer.

An embodiment is implemented such that metal nano-pattern filter technology can be applied to a CMOS process including the photo-lithography process, so that it is possible to quite freely adjust the transmission band and transmittance, even with a small number of metal layers.

Also, in embodiments, it is possible to enhance the characteristics of the metal optical filter and to enhance the stability of the process.

Moreover, in embodiments, it is possible to perform a nanoscale patterning on a metal layer for a circuit wiring by using the metal layer as an optical filter, even without a separate optical filter, so that processing time and cost can be saved.

In the drawings:
FIG. 1 is a view illustrating a band-pass filter which has a nanoscale pattern formed on a metal layer;
FIG. 2 is a view illustrating the structure of a metal optical filter capable of a photo-lithography process according to an embodiment of the present invention;
FIG. 3 is a view illustrating the transmission spectrums of TE and TM modes in the structure shown in FIG. 2;
FIG. 4 shows a change in a transmission spectrum depending on a variation of a pitch in the structure shown in FIG. 2;
FIG. 5 is a view illustrating the structure of a metal optical filter capable of a photo-lithography process according to another embodiment of the present invention;
FIG. 6 is a view showing a case where the surface is processed with Si02 in the structure shown in FIG. 5 according to an embodiment of the present invention;
FIG. 7 is a view illustrating the structure of a metal optical filter capable of a photo-lithography process according to still another embodiment of the present invention;
FIG. 8 is a view illustrating a transmission spectrum depending on a variation in a pitch in the structure shown in FIG. 5;
FIG. 9 is a view showing a change in a transmission spectrum depending on the thickness of Al in the structure shown in FIG. 2; and
FIG. 10 is a cross sectional view illustrating an image sensor in which a metal optical filter shown in any one of FIG. 2 and FIGs. 5 to 7 is applied to a metal layer for circuit wiring.

Referring to FIG. 2, an embodiment of a metal optical filter capable of a photo-lithography process has a plurality of metal rods 1, which have lengths longer than widths thereof and are arranged in parallel with each other at the same nanoscale interval, and an insulation material 2 formed between the plurality of metal rods 1 and on the upper/lower surfaces of the plurality of metal rods 1, wherein each metal rod 1 is formed to include an upper TiN layer, an upper Ti layer, an Al layer, a lower TiN layer, and a lower Ti layer.

In other embodiments, the metal rod 1 of the metal optical filter may have either a structure including an upper TiN layer, an Al layer, a lower TiN layer, and a lower Ti layer, or a structure including an upper TiN layer, an Al layer, and a lower TiN layer.

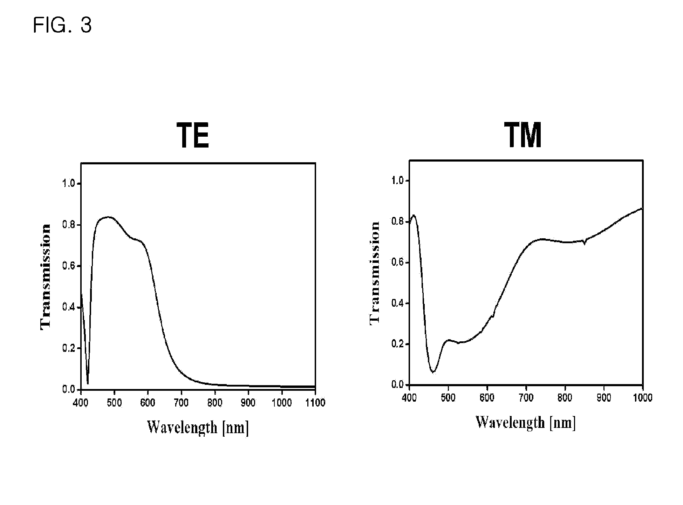

When light is perpendicularly incident, an electric field and a magnetic field may be classified into a parallel component and a perpendicular component with respect to the metal rod. A transmission spectrum when the electric field is a parallel component to the metal rod, that is, a transmission spectrum in a transverse electric mode (TE mode), is shown with letters "TE" in FIG. 3. In addition, a transmission spectrum when the magnetic field is a parallel component to the metal rod, that is, a transmission spectrum in a transverse magnetic mode (TM mode), is shown with letters "TM" in FIG. 3.

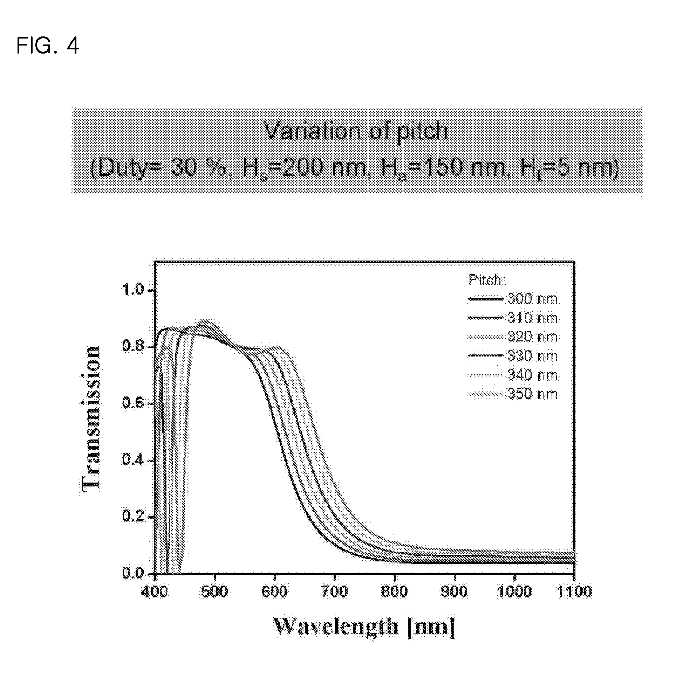

In this case, a change in the transmission spectrum depending on a pitch P, which is a periodic distance, is shown in FIG. 4. FIG. 4 shows a transmission spectrum characteristic when the metal rod 1 includes an upper insulation material (Si02) with a thickness Hs of 150 nm, a lower Ti layer with a thickness Ht of 5 nm, and an Al layer with a thickness Ha of 150 nm, and has a pitch P in a range of 300 to 350 nm in the metal optical filter of FIG. 2. Referring to FIG. 4, it is possible to determine a transmittance and a selection wavelength range by adjusting the pitch P.

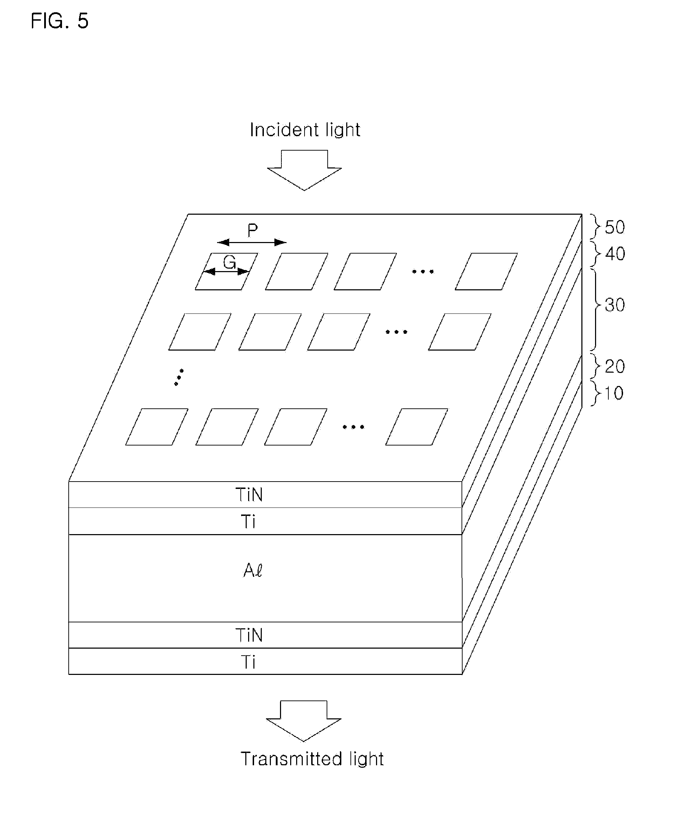

A metal optical filter capable of a photo-lithography process according to another embodiment of the present invention has a structure as shown in FIG. 5.

Referring to FIG. 5, the metal optical filter includes a lower Ti layer 10 formed to enhance an adhesive force with a lower material of the metal optical filter, a lower TiN layer 20 formed on the top of the lower Ti layer 10 so as to prevent diffusion of Al, an Al layer 30 formed on the top of the lower TiN layer 20, an upper Ti layer 40 formed on the top of the Al layer 30, and an upper TiN layer 50 formed on the top of the upper Ti layer 40 so as to prevent reflection of light in a photo-lithography process. The upper TiN layer 50, the upper Ti layer 40, the Al layer 30, the lower TiN layer 20, and the lower Ti layer 10 are patterned to form a plurality of nanoscale apertures.

In addition, a metal optical filter according to another embodiment of the present invention may have either a structure including an upper TiN layer, an Al layer, a lower TiN layer, and a lower Ti layer, or a structure including an upper TiN layer, an Al layer, and a lower TiN layer.

As shown in FIG. 5, the plurality of apertures has a structure in which the halls with the same size are repeatedly formed in a specified lattice period "P."

In addition, the plurality of apertures formed in the metal optical filter are filled with insulation material, such as Si02.

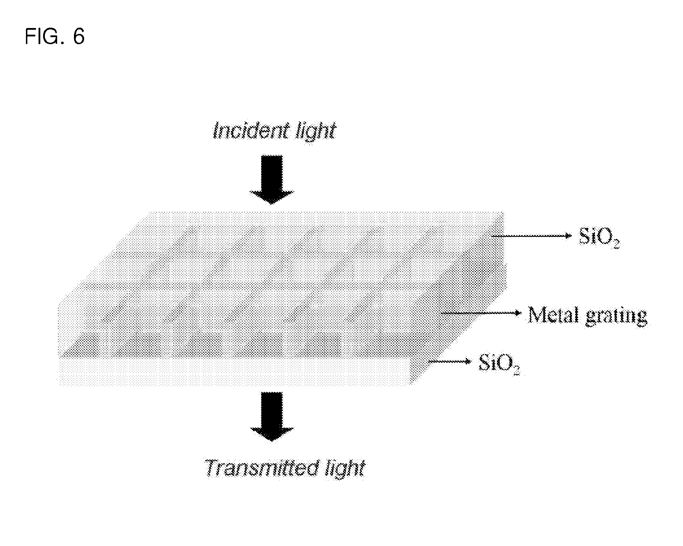

Also, as shown in FIG. 6, an Si02 layer may be formed on the top and/or bottom of the metal optical filter according to the present invention.

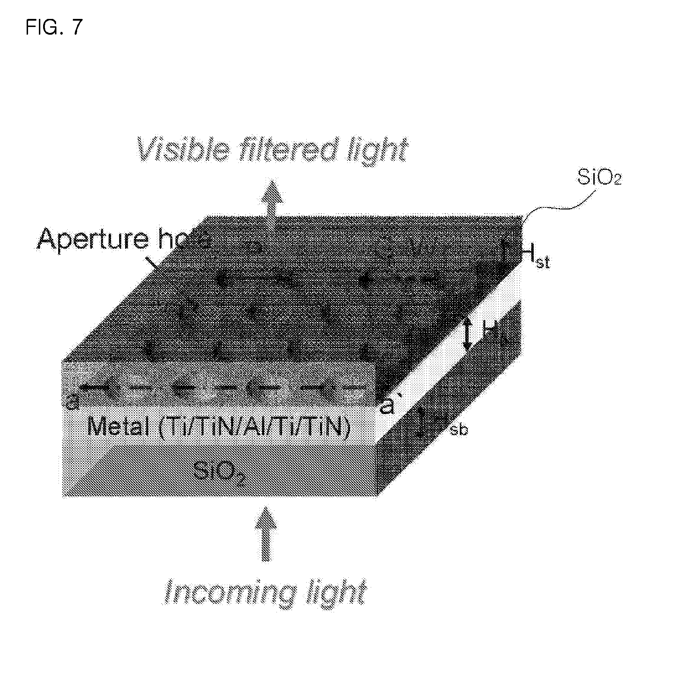

According to still another embodiment of the present invention, a plurality of apertures may be formed in a cylindrical shape, which is shown in FIG. 7. In the metal optical filter of FIG. 7, a plurality of apertures with a cylindrical shape are formed in TiN layer/Ti layer/Al layer/TiN layer/Ti layer, and Si02 layers are formed on the top and bottom of the plurality of apertures and TiN layer/Ti layer/Al layer/TiN layer/Ti layer.

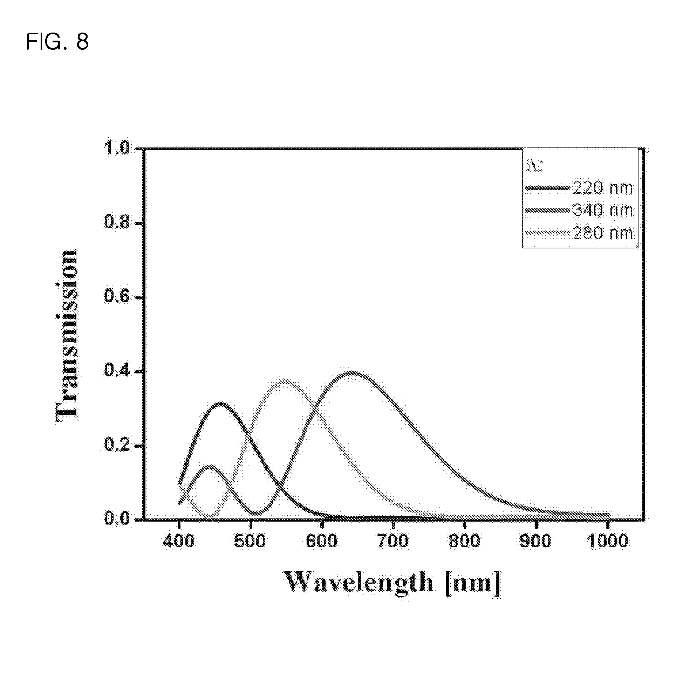

According to an embodiment of the present invention, the lattice period P is 300 nm. The lattice period varies depending on transmission wavelength bands, and has a range of approximately 100 to 500 nm in the visible band and the infrared band. A change in transmittance depending on lattice periods is shown in FIG. 8.

FIG. 8 is a transmittance spectrum of the metal optical filter shown in FIG. 5.

Referring to FIG. 8, the metal optical filter shown in FIG. 5 transmits light in a wavelength range of 400 to 600 nm according to variation in the thickness of the Al layer, and has a transmittance of approximately 30% at a wavelength of 450 nm.

The lattice period P is determined according to the wavelength of light to be transmitted, and must be less than the wavelength of light to be transmitted. Also, since the inside diameter G of the aperture determines the transmittance, it is preferred that the inside diameter has the maximum size that allows a pattern to be formed.

For example, when the width of metal wiring is limited to 90 nm, the inside diameter G may be determined by "G=P-90 [nm]."

In the metal optical filter shown in FIG. 5, each of the lower Ti layer 10, the lower TiN layer 20, the upper Ti layer 40, and the upper TiN layer 50 has a thickness of 10 nm, and the Al layer 30 has a thickness of 150 nm.

Here, it is preferred that the lower TiN layer 20 and the upper TiN layer 50 have a thickness in a range of 5 to 20 nm. In addition, the thickness of the Al layer 30 is related to the transmittance. That is to say, as the Al layer becomes thicker, the transmittance decreases while the selectivity increases, and as the Al layer becomes thinner, the transmittance increases while the selectivity decreases. Therefore, it is preferred that the thickness of the Al layer 30 is designed by taking the transmittance and selectivity into consideration.

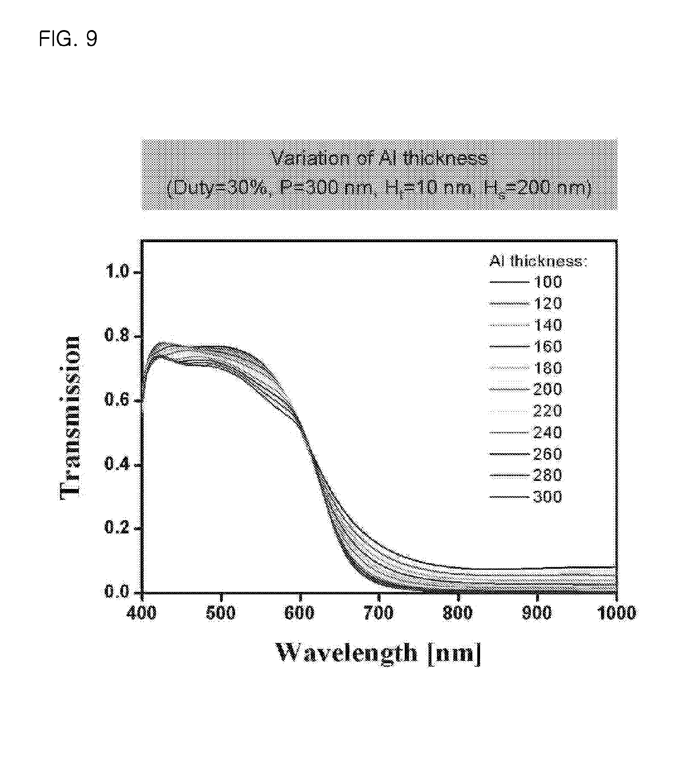

FIG. 9 is a view showing a change in a transmission spectrum depending on the thickness of the Al layer in the structure shown in FIG. 2. Such a structure has the same transmittance without distinction between the TE mode and the TM mode.

Referring to FIG. 9, it can be understood that the transmittance and selection wavelength range vary depending on the thickness of the Al layer.

In addition, according to still another embodiment of the present invention, a metal optical filter may be formed in a structure that the patterns of the apertures and metal layer, shown in FIGs. 5 to 7, are exchanged. That is to say, the metal layer may be formed in a hexahedral or cylindrical shape.

This is only one example, and the transmission band and transmittance of a metal optical filter according to the present invention can be easily and freely controlled by changing the thickness of each metal layer (i.e. Ti layer, Al layer, and TiN layer) including the Al layer, the lattice interval, the wiring width of each metal wiring, and a duty ratio of the aperture.

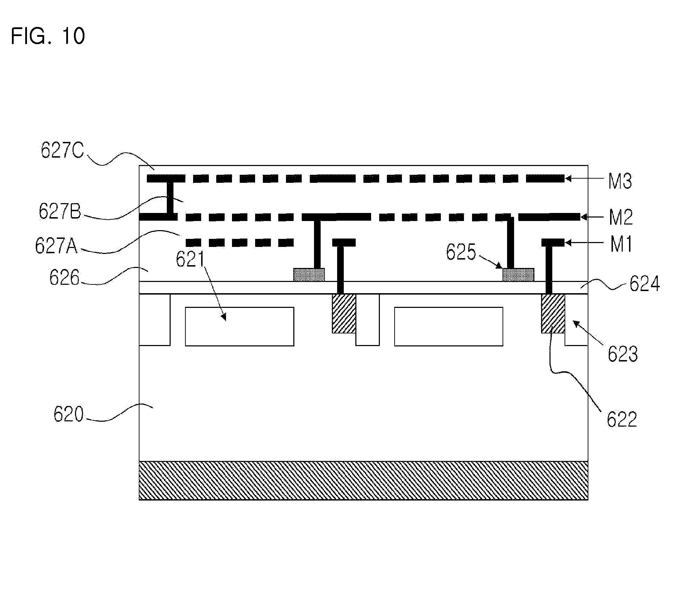

FIG. 10 is a cross sectional view illustrating an image sensor in which a metal optical filter shown in FIG. 2 and FIGs. 5 to 7 is applied to a metal layer for circuit wiring.

The image sensor includes a substrate 620 having a photodiode region 621 which detects light, a vertical charge transfer region 622 which is a charge transfer path where electric charges generated by an photoelectric effect in the photodiode region 621 are collected, and an isolation layer (STI) 623; a gate insulation film 624 formed on the substrate 620; a gate electrode 625 formed on the gate insulation film 624; an interlayer insulation film 626 formed on the substrate having the gate electrode 625; and at least one metal layer M1 to M3 formed, with an insulation film interposed, to provide a circuit wiring within the interlayer insulation film 626, wherein at least one band-pass filter 627A to 627C formed in a structure (i.e. structure of Ti layer/upper TiN layer/Al layer/lower TiN layer/Ti layer) as shown in FIG. 2 is formed on the at least one band-pass filter 627A to 627C.

The light incident to the image sensor passes through at least one band-pass filter 627A to 627C, and light of only a selected wavelength band is incident to the photodiode region 621. The band-pass filter may be applied to a single metal layer M3. When the band-pass filter is applied to a plurality of metal layers M1 to M3, color purity can be improved.

Since the thickness, material, and pattern distance of the metal layers M1 to M3 having at least one band-pass filter 627A to 627C are the same as those described above, so a detailed description thereof will be omitted.

As described with reference to FIG. 10, when an optical band-pass filter is formed by forming nanoscale patterns having mutually different transmission bands on the metal layers M1 to M3, the wavelength of light incident to the photodiode region 621 can be accurately determined. That is to say, since the transmission spectrum of the image sensor is determined by multiplication of the transmission spectrums of the metal layers M1 to M3, a filter having a narrow transmission band can be easily implemented.

The metal optical filter according to the present invention solves the disadvantages of the conventional metal nano-pattern filter, as described below.

First, since Al, TiN, and Ti are used in place of Ag which cannot be applied in a CMOS process, it is possible to implement the metal nano-pattern filter technology to be actually applied in the CMOS process.

Second, in order to solve the problem that it is difficult to apply a metal optical filter to a photo-lithography process due to the usage of a metal, such as Ag, having a high reflectivity, a TiN layer is deposited on the uppermost surface of a metal optical filter, so that it is possible to perform the photo-lithography process for forming a nanoscale pattern.

In addition, according to the metal optical filter based on the present invention, the lower TiN layer is deposited on the lower surface of the Al layer in order to prevent diffusion of Al, and the lower Ti layer is deposited on the lower surface of the lower TiN layer in order to enhance the adhesive force between the metal optical filter and the insulation material (Si02) of the substrate on which the metal optical filter is formed, so that it is possible to enhance the characteristics of the metal optical filter and to enhance the stability of the process.

Moreover, according to the image sensor based on an embodiment of the present invention, a nanoscale patterning can be performed on a metal layer for a circuit wiring by using the metal layer as an optical filter, even without a separate optical filter, so that it is possible to save processing time and cost.

Although a preferred embodiment of the present invention has been described for illustrative purposes, those skilled in the art will appreciate that various modifications, additions and substitutions are possible, without departing from the scope of the invention as recited in the accompanying claims.

## Claims

1. A metal optical filter capable of a photo-lithography process, the metal optical filter comprising:
a plurality of metal rods arranged in parallel with each other at an equal nanoscale interval; and
an insulation material formed between the plurality of metal rods and on upper and lower surfaces of the plurality of metal rods,
wherein the metal rod is formed to comprise an upper Ti layer, an Al layer, and a lower TiN layer.

2. The metal optical filter according to claim 1, wherein the metal rod further comprises an upper Ti layer additionally formed between the Al layer and the upper TiN layer.

3. The metal optical filter according to claim 2, wherein the metal rod further comprises a lower Ti layer additionally formed between the lower TiN layer and the insulation material formed on the lower surface.

4. The metal optical filter according to claim 1, wherein the metal rod has a hexahedral shape with a length thereof longer than a width thereof.

5. A metal optical filter capable of a photo-lithography process, the metal optical filter comprising:
a lower TiN layer;
an Al layer formed on an upper surface of the lower TiN layer; and
an upper TiN layer formed on an upper surface of the Al layer,
wherein a plurality of nanoscale apertures are patterned on the upper TiN layer, the Al layer, and the lower TiN layer.

6. The metal optical filter according to claim 5, wherein an upper Ti layer is additionally formed between the Al layer and the upper TiN layer.

7. The metal optical filter according to claim 6, wherein a lower Ti layer is additionally formed on a lower surface of the lower TiN layer.

8. The metal optical filter according to claim 5, wherein cross sections of the apertures have a quadrangular shape or circular shape.

9. The metal optical filter according to claim 5, wherein the plurality of apertures has a structure that the apertures with an equal size are repeatedly formed in a predetermined lattice period.

10. The metal optical filter according to claim 9, wherein the lattice period is in a range greater than or equal to 100 nm and less than or equal to 500 nm.

11. The metal optical filter according to claim 10, wherein the apertures have a maximum size within a range in which a pattern can be formed by taking the lattice period and a wiring width of the Al layer into consideration.

12. The metal optical filter according to claim 5, wherein a thickness of the Al layer or a lattice period of the apertures in the Al layer is determined depending on a wavelength and transmittance of light transmitted to the metal optical filter.

13. The metal optical filter according to claim 5, wherein a ratio of a wiring width to a length of each aperture is determined depending on a wavelength and transmittance of light transmitted to the metal optical filter.

14. The metal optical filter according to claim 5, wherein the plurality of apertures are filled with Si02.

15. The metal optical filter according to claim 5, wherein Si02 is formed in upper and lower portions of the metal optical filter.

16. An image sensor comprising a metal optical filter capable of a photo-lithography process, the image sensor comprising:
a substrate having a photodiode region which detects light, a vertical charge transfer region which is a charge transfer path where electric charges generated by an photoelectric effect in the photodiode region are collected, and an isolation layer;
a gate insulation film formed on the substrate;
a gate electrode formed on the gate insulation film;
an interlayer insulation film formed on the substrate having the gate electrode; and
at least one metal layer formed with an insulation film interposed therebetween to provide a circuit wiring within the interlayer insulation film,
wherein the at least one metal layer corresponds to the metal optical filter according to claim 1.

17. The image sensor as claimed in claim 16, wherein the at least one metal layer has mutually different transmission bands.

18. An image sensor comprising a metal optical filter capable of a photo-lithography process, the image sensor comprising:
a substrate having a photodiode region which detects light, a vertical charge transfer region which is a charge transfer path where electric charges generated by an photoelectric effect in the photodiode region are collected, and an isolation layer;
a gate insulation film formed on the substrate;
a gate electrode formed on the gate insulation film;
an interlayer insulation film formed on the substrate having the gate electrode; and
at least one metal layer formed with an insulation film interposed therebetween to provide a circuit wiring within the interlayer insulation film,
wherein the at least one metal layer corresponds to the metal optical filter according to claim 5.

19. The image sensor as claimed in claim 18, wherein the at least one metal layer has mutually different transmission bands.
